(19) Europäisches Patentamt
European Patent Office
Office européen des brevets

(11) **EP 4 772 492 A1**

(12) **EUROPEAN PATENT APPLICATION**
published in accordance with Art. 153(4) EPC

(43) Date of publication:
**08.07.2026 Bulletin 2026/28**

(21) Application number: 24859340.2

(22) Date of filing: 02.08.2024

(51) International Patent Classification (IPC):
*C04B 35/495* (2006.01)   *H10N 30/20* (2023.01)
*H10N 30/30* (2023.01)   *H10N 30/853* (2023.01)

(52) Cooperative Patent Classification (CPC):
**C04B 35/495; H10N 30/20; H10N 30/30; H10N 30/853**

(86) International application number:
**PCT/JP2024/027793**

(87) International publication number:
**WO 2025/047298 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.08.2023 JP 2023141457**

(71) Applicant: Niterra Co., Ltd.
**Nagoya-shi, Aichi 461-0005 (JP)**

(72) Inventors:
• **HIROSE, Yoshinobu**
**Nagoya-shi, Aichi 461-0005 (JP)**
• **MARUYAMA, Koji**
**Nagoya-shi, Aichi 461-0005 (JP)**
• **KASASHIMA, Takashi**
**Nagoya-shi, Aichi 461-0005 (JP)**
• **YAMAZAKI, Masato**
**Nagoya-shi, Aichi 461-0005 (JP)**

(74) Representative: J A Kemp LLP
**80 Turnmill Street**
**London EC1M 5QU (GB)**

(54) **LEAD-FREE PIEZOELECTRIC COMPOSITION, PIEZOELECTRIC ELEMENT, AND DEVICE**

(57) The lead-free piezoelectric composition includes a primary phase formed of an alkali niobate-based perovskite oxide, and a secondary phase containing a compound which has a tungsten bronze-type structure including niobium (Nb) and at least one species selected from among barium (Ba), calcium (Ca), strontium (Sr), sodium (Na), and potassium (K). The he secondary phase satisfies at least one condition among three conditions in relation to 80% cumulative frequency grain size (D80), 50% cumulative frequency grain size (D50), and 20% cumulative frequency grain size (D20), in a volume-based grain size distribution, represented by the following numerical expressions (1) to (3):

$$1.3 \ \mu m \leq D80 \leq 218.6 \ \mu m \quad \cdots \quad (1),$$

$$0.4 \ \mu m \leq D50 \leq 68.7 \ \mu m \cdots (2), \text{ and}$$

$$0.1 \ \mu m \leq D20 \leq 22.2 \ \mu m \quad \cdots \quad (3).$$

FIG. 12

| | PRIMARY PHASE | SECONDARY PHASE COMPOSITION | D20 (μm) | D50 (μm) | D80 (μm) | Qm | tan δ (%) | SCORE |
|---|---|---|---|---|---|---|---|---|
| S1 | A | — | — | — | — | 117 (×) | 5.0 (×) | × |
| S2 | A | $Ba_2KNb_5O_{15}$ | 0.1 | 0.4 | 1.3 | 712 (○) | 0.9 (○) | ○ |
| S3 | A | $Ba_2KNb_5O_{15}$ | 1.1 | 1.9 | 8.0 | 753 (○) | 0.9 (○) | ○ |
| S4 | A | $Ba_2KNb_5O_{15}$ | 3.4 | 25.6 | 89.7 | 915 (○) | 0.7 (○) | ○ |
| S5 | A | $Ba_2KNb_5O_{15}$ | 6.7 | 60.7 | 155.2 | 791 (○) | 0.9 (○) | ○ |
| S6 | A | $Ba_2KNb_5O_{15}$ | 22.2 | 68.7 | 218.6 | 631 (○) | 0.9 (○) | ○ |
| S7 | A | $Ba_2KNb_5O_{15}$ | 28.4 | 88.1 | 328.5 | 218 (△) | 3.8 (×) | × |
| S8 | A | $BaSrKNb_5O_{15}$ | 2.3 | 10.5 | 18.5 | 891 (○) | 0.7 (○) | ○ |
| S9 | A | $BaCaKNb_5O_{15}$ | 4.1 | 30.6 | 67.2 | 865 (○) | 0.8 (○) | ○ |
| S10 | A | $Sr_2NaNb_5O_{15}$ | 3.3 | 21.7 | 60.5 | 832 (○) | 0.8 (○) | ○ |
| S11 | A | $Ba_2NaNb_5O_{15}$ | 2.8 | 18.3 | 42.2 | 901 (○) | 0.8 (○) | ○ |
| S12 | A | $Ba_2(K_{0.5}Na_{0.5})Nb_5O_{15}$ | 3.1 | 21.8 | 50.2 | 831 (○) | 0.9 (○) | ○ |
| S13 | A | $Ba_2KNb_5O_{15}$ | 21.3 | 90.3 | 335.8 | 671 (○) | 0.9 (○) | ○ |
| S14 | A | $Ba_2KNb_5O_{15}$ | 29.8 | 62.3 | 339.6 | 637 (○) | 0.9 (○) | ○ |
| S15 | A | $Ba_2KNb_5O_{15}$ | 30.3 | 91.3 | 204.1 | 656 (○) | 0.8 (○) | ○ |
| S16 | A | $Ba_2KNb_5O_{15}$ | 21.3 | 65.5 | 332.5 | 651 (○) | 0.9 (○) | ○ |
| S17 | A | $Ba_2KNb_5O_{15}$ | 30.8 | 61.3 | 198.7 | 666 (○) | 0.8 (○) | ○ |
| S18 | A | $Ba_2KNb_5O_{15}$ | 19.5 | 89.5 | 208.3 | 656 (○) | 0.9 (○) | ○ |
| S19 | A | $Ba_2KNb_5O_{15}$ | 28.3 | 55.9 | 185.9 | 678 (○) | 0.9 (○) | ○ |

EP 4 772 492 A1

**Description**

TECHNICAL FIELD

The present disclosure relates to a lead-free piezoelectric composition, to a piezoelectric element, and to a device.

BACKGROUND ART

Hitherto, PZT-based (lead zirconate titanate-based) compositions which exhibit piezoelectricity have been widely used. However, for reducing and environmental load and for other reasons, there is demand for the development of a lead-free piezoelectric composition which contains no lead. As a candidate of such a lead-free piezoelectric composition, there has been proposed, for example, an alkali niobate-based perovskite oxide. However, the alkali niobate-based perovskite oxide has a problem of possibly insufficient sinterability.

In order to enhance the sinterability of such an alkali niobate-based perovskite oxide, there have been proposed technical means in which the lead-free piezoelectric composition includes a primary phase formed of an alkali niobate-based perovskite oxide and, additionally, a secondary phase formed of another oxide (see, for example, Patent Literatures 1 to 4). More specifically, Patent Literature 1 discloses provision of a secondary phase containing an M-Ti-O-type spinel compound (wherein element M represents a 1 to 4-valent element). Patent Literature 2 discloses provision of a secondary phase containing a spinel compound represented by $(M4,Ti)O_4$ (wherein metal element M4 represents at least one of Fe, Co, and Zn). Patent Literature 3 discloses provision of a secondary phase containing a spinel compound which includes Ti. Patent Literature 4 discloses provision of a secondary phase formed of one type of the oxides selected from an oxide represented by a compositional formula $A2_{1-x}Ti_{1-x}Nb_{1+x}O_5$ (wherein element A2 represents at least one alkali metal, satisfying $0 \leq x \leq 0.15$) and an oxide represented by a compositional formula $A3Ti_3NbO_9$ (wherein element A3 represents at least one alkali metal).

CITATION LIST

PATENT LITERATURE

Patent Literature 1: JP5715309B
Patent Literature 2: JP6895845B
Patent Literature 3: WO2022-215666A
Patent Literature 4: WO2023-026614A

SUMMARY OF INVENTION

TECHNICAL PROBLEM

Such a piezoelectric composition is required to have an enhanced mechanical quality factor Qm and a reduced dielectric loss (dielectric tangent) tanδ, which is a reciprocal of mechanical quality factor Qm. Mechanical quality factor Qm is a parameter which represents sharpness of the resonance spectrum of a piezoelectric element. By virtue of an increase in mechanical quality factor Qm, the piezoelectric element can be effectively vibrated. However, no sufficient elucidation has been made in relation to the mechanical quality factor Qm and dielectric loss tanδ of a lead-free piezoelectric composition, and enhancement in mechanical quality factor Qm and reduction in dielectric loss tanδ are further sought.

SOLUTION TO PROBLEM

The present disclosure may be carried out as the following aspects.

[1] In one aspect of the present disclosure, a lead-free piezoelectric composition is provided. The lead-free piezoelectric composition includes a primary phase formed of an alkali niobate-based perovskite oxide, and a secondary phase containing a compound which has a tungsten bronze-type structure including niobium (Nb) and at least one species selected from among barium (Ba), calcium (Ca), strontium (Sr), sodium (Na), and potassium (K). The secondary phase satisfies at least one condition among three conditions in relation to a 80% cumulative frequency grain size (D80), a 50% cumulative frequency grain size (D50), and a 20% cumulative frequency grain size (D20), in a volume-based grain size distribution, represented by the following numerical expressions (1) to (3):

$$1.3 \ \mu m \leq D80 \leq 218.6 \ \mu m \quad \cdots \quad (1),$$

$$0.4 \ \mu m \leq D50 \leq 68.7 \ \mu m \quad \cdots \quad (2),$$

and

$$0.1 \ \mu m \leq D20 \leq 22.2 \ \mu m \quad \cdots \quad (3).$$

According to the lead-free piezoelectric composition according to the above aspect, in the lead-free piezoelectric composition including a primary phase formed of an alkali niobate-based perovskite oxide, when at least one condition among three conditions, represented by the following numerical expressions (1) to (3), in relation to the grain size in the secondary phase containing the aforementioned compound having a tungsten bronze-type structure is satisfied, the mechanical quality factor Qm of the lead-free piezoelectric composition can be enhanced, and the dielectric loss $\tan\delta$ thereof can be reduced.

[2] In the secondary phase of the lead-free piezoelectric composition according to the above aspect, the 80% cumulative frequency grain size (D80) in the volume-based grain size distribution satisfies the aforementioned numerical expression (1) and may further satisfy the following numerical expression (4):

$$1.3 \ \mu m \leq D80 \leq 155.2 \ \mu m \quad \cdots \quad (4).$$

According to the above technical feature, the effects of enhancing the mechanical quality factor Qm of the lead-free piezoelectric composition and reducing the dielectric loss $\tan\delta$ thereof can be further enhanced.

[3] In the secondary phase of the lead-free piezoelectric composition according to the above aspect, the 50% cumulative frequency grain size (D50) in the volume-based grain size distribution satisfies the aforementioned numerical expression (2) and may further satisfy the following numerical expression (5):

$$0.4 \ \mu m \leq D50 \leq 60.7 \ \mu m \quad \cdots \quad (5).$$

According to the above technical feature, the effects of enhancing the mechanical quality factor Qm of the lead-free piezoelectric composition and reducing the dielectric loss $\tan\delta$ thereof can be further enhanced.

[4] In the secondary phase of the lead-free piezoelectric composition according to the above aspect, the 20% cumulative frequency grain size (D20) in the volume-based grain size distribution satisfies the aforementioned numerical expression (3) and may further satisfy the following numerical expression (6):

$$0.1 \ \mu m \leq D20 \leq 6.7 \mu m \quad \cdots \quad (6).$$

According to the above technical feature, the effects of enhancing the mechanical quality factor Qm of the lead-free piezoelectric composition and reducing the dielectric loss $\tan\delta$ thereof can be further enhanced.

[5] In the lead-free piezoelectric composition according to the above aspect, the alkali niobate-based perovskite-type oxide forming the primary phase may contain manganese (Mn). According to the technical feature, the effects of enhancing the mechanical quality factor Qm of the lead-free piezoelectric composition and reducing the dielectric loss $\tan\delta$ thereof can be further enhanced.

[6] In the lead-free piezoelectric composition according to the above aspect, the alkali niobate-based perovskite-type oxide forming the primary phase may include a primary phase formed of an alkali niobate-based perovskite-type oxide represented by a compositional formula $(A1_a M1_b)_c (Nb_{d1}, Mn_{d2}, M2_{d3})O_{3+e}$ (in which element A1 represents at least one alkali metal; element M1 represents at least one of Ba, Ca, and Sr; element M2 represents at least one of Ti and Zr; conditions: $0<a<1$, $0<b<1$, and $a+b=1$ are satisfied; c satisfies a condition: $0.80<c<1.10$; conditions: $0<d1<1$, $0<d2<1$, $0<d3<1$, and $d1+d2+d3=1$ are satisfied; and e is a value showing oxygen deficiency or excess), and satisfy a condition: $b/(d2+d3)>1.0$. According to the technical feature, the effects of enhancing the mechanical quality factor Qm of the lead-free piezoelectric composition and reducing the dielectric loss $\tan\delta$ thereof can be further enhanced.

[7] In another aspect of the present disclosure, there is provided a piezoelectric element having a piezoelectric body formed of a lead-free piezoelectric composition as recited in any one of [1] to [6] above, and an electrode attached to the piezoelectric body. The piezoelectric element of the aspect includes a piezoelectric body formed of a lead-free piezoelectric composition that can provide an enhanced mechanical quality factor Qm and a reduced dielectric loss tan$\delta$, whereby piezoelectric performance can be further enhanced.

[8] In still another aspect of the present disclosure, there is provided a device having a piezoelectric element as recited in [7] above.

The device of the aspect has a piezoelectric element including a lead-free piezoelectric composition that can provide an enhanced mechanical quality factor Qm and a reduced dielectric loss tan$\delta$, whereby total performance of the device can be enhanced.

The present disclosure can be carried out as a variety of embodiments, for example, a lead-free piezoelectric composition, a piezoelectric element employing the composition, various devices employing the piezoelectric element (e.g., a knock sensor, an ultrasonic vibrator, a cutting tool, an ultrasonic sensor, or an actuator), a method manufacturing a lead-free piezoelectric composition, etc.

BRIEF DESCRIPTION OF DRAWINGS

[FIG. 1] Perspective view of an appearance of a piezoelectric element.

[FIG. 2] Flowchart showing an example of a piezoelectric element manufacturing method.

[FIG. 3] Schematic view of an ultrasonic surgical knife as an example of the device.

[FIG. 4] Schematic view of an ultrasonic scaler as an example of the device.

[FIG. 5] Schematic view of an ultrasonic cleaning machine as an example of the device.

[FIG. 6] Schematic view of an ultrasonic processing machine as an example of the device.

[FIG. 7] Schematic view of a piezoelectric transducer as an example of the device.

[FIG. 8] Schematic view of an ultrasonic motor as an example of the device.

[FIG. 9] Schematic view of a piezoelectric gyro sensor as an example of the device.

[FIG. 10] Schematic view of a stacked piezoelectric filter as an example of the device.

[FIG. 11] Schematic view of a knock sensor as an example of the device.

[FIG. 12] A table (i.e., a schematic drawing) collectively showing features of samples and results of evaluation.

[FIG. 13] A table collectively showing features of samples and results of evaluation.

[FIG. 14] A table collectively showing features of samples and results of evaluation.

[FIG. 15] A table showing primary phase features of samples.

[FIG. 16] A table showing secondary phase calcined powders for forming a secondary phase in each sample..

DESCRIPTION OF EMBODIMENTS

A. Lead-free piezoelectric composition:

The lead-free piezoelectric composition of the present embodiment includes a primary phase formed of an alkali niobate-based perovskite oxide, and a secondary phase containing a compound which has a tungsten bronze-type structure including niobium (Nb) and at least one species selected from among barium (Ba), calcium (Ca), strontium (Sr), sodium (Na), and potassium (K). The secondary phase satisfies at least one condition among three conditions in relation to a 80% cumulative frequency grain size (D80), a 50% cumulative frequency grain size (D50), and a 20% cumulative frequency grain size (D20), in a volume-based grain size distribution, represented by the following numerical expressions (1) to (3).

$$1.3\ \mu m \leq D80 \leq 218.6\ \mu m \quad \cdots \quad (1)$$

$$0.4\ \mu m \leq D50 \leq 68.7\ \mu m \quad \cdots \quad (2)$$

$$0.1\ \mu m \leq D20 \leq 22.2\ \mu m \quad \cdots \quad (3)$$

(A-1) Primary phase:

The alkali niobate-based perovskite oxide forming the primary phase preferably contains, as an alkaline component, at least one species among alkali metals (e.g., potassium (K), sodium (Na), and lithium (Li)), particularly preferably at least one of potassium (K) and sodium (Na). Also, the alkali niobate-based perovskite oxide forming the primary phase may contain, as an alkaline component, an alkaline earth metal (i.e., at least one species of calcium (Ca), strontium (Sr), barium (Ba), etc.).

The alkali niobate-based perovskite-type oxide forming the primary phase may further contain manganese (Mn). Conceivably, when manganese (Mn) serving as an acceptor forms a solid solution at niobium sites (i.e., B site of a perovskite-type crystal structure), mechanical quality factor Qm can be enhanced.

In addition, the alkali niobate-based perovskite oxide forming the primary phase is preferably an alkali niobate-based perovskite-type oxide satisfying the following compositional formula (7).

$$(A1_a M1_b)_c (Nb_{d1}, Mn_{d2}, M2_{d3}) O_{3+e} \cdots \qquad (7)$$

In the formula, element A1 represents at least one alkali metal; element M1 represents at least one of Ba, Ca, and Sr; element M2 represents at least one of Ti and Zr; conditions: $0<a<1$, $0<b<1$, and $a+b=1$ are satisfied; c satisfies a condition: $0.80<c<1.10$; conditions: $0<d1<1$, $0<d2<1$, $0<d3<1$, and $d1+d2+d3=1$ are satisfied; and e is a value showing oxygen deficiency or excess, and a condition: $b/(d2+d3)>1.0$ is satisfied.

In the aforementioned compositional formula (7), element A1 and element M1 are present in the A site of the perovskite structure, and Nb (niobium), Mn (manganese), and element M2 are present in the B site. In the compositional formula (7), coefficients a to e are selected from the aforementioned values which are preferred from the viewpoints of electrical characteristics and piezoelectric characteristics of the lead-free piezoelectric composition, so long as the combination of coefficients a to e ensures establishment of the perovskite structure. In the alkali niobate-based perovskite oxide represented by compositional formula (7), the cases of a=0 (i.e., the composition containing no alkali metal), b=0 (i.e., the composition containing none of Ca, Sr, and Ba), d1=0 (i.e., the composition containing no Nb), d2=0 (i.e., the composition containing no Mn), and d3=0 (i.e., the composition containing no Ti or Zr) are excluded.

In coefficient (3+e) with respect to oxygen, the value of e is a positive or negative value showing deviation (deficiency or excess) from the intrinsic value of 3 with respect to oxygen. Coefficient (3+e) with respect to oxygen may be a value which allows the primary phase to have a perovskite oxide structure. Typically, coefficient e is 0, and preferably satisfies $-0.1 \leq e \leq 0.1$. Notably, coefficient e may also be calculated from the composition of the primary phase to meet the electrically neutral condition. However, needless to say, a composition of the primary phase which is slightly deviated from the electrically neutral condition is also allowable.

As mentioned above, when coefficients b, d2, and d3 satisfy the condition: $b/(d2+d3)>1.0$ in the aforementioned compositional formula (7), a lead-free piezoelectric composition which exhibits high mechanical quality factor Qm can be yielded. A conceivable reason for this is as follows. Specifically, when Mn serving as an acceptor forms a solid solution in Nb sites, mechanical quality factor Qm can be conceivably enhanced. However, difficulty is encountered in formation of a solid solution of Mn with an alkali niobate-based perovskite oxide, and Mn tends to segregate to form a foreign phase in the lead-free piezoelectric composition. Solid solution-formability is thought to depend on the ionic radius and valence of a metal atom involved in formation of solid solution, and difficulty is encountered in forming a solid solution of trivalent Mn in B sites where pentavalent Nb mainly occupies. Meanwhile, divalent metals Ba, Ca, and Sr easily form a solid solution in A sites allocated for monovalent alkali metals. It is assumed that, when appropriate amounts of Ba, Ca, and Sr having a valence closer to the valence of Mn are incorporated into A sites to form a solid solution, formation of a solid solution of Mn in B sites is facilitated. Thus, conceivably, by adjusting the compositional proportions of Ba, Ca, and Sr to Mn to be $b/(d2+d3)>1.0$, an appropriate amount of Mn forms a solid solution in B sites, thereby enhancing mechanical quality factor Qm. No particular limitation is imposed on the upper limit of $b/(d2+d3)$, but the ratio $b/(d2+d3)$ is preferably 2.0 or less.

(A-2) Secondary phase:

As mentioned above, the secondary phase of the lead-free piezoelectric composition of the present embodiment contains a compound which has a tungsten bronze-type structure including niobium (Nb) and at least one species selected from among barium (Ba), calcium (Ca), strontium (Sr), sodium (Na), and potassium (K). The compound having a tungsten bronze-type structure is a compound represented by the following formula (8).

$$A_k B_l O_{15+\delta} \cdots \qquad (8)$$

In the above formula, A includes two or more monovalent or divalent elements; B includes one or more divalent to pentavalent elements; and k=3, l=5, and $\delta$=0 are satisfied in a typical case. So long as the tungsten bronze-type structure can be maintained, and variation in characteristics of the compound fall within an allowable range, the values of k, 1, and $\delta$ may be deviated from the above typical values. Also, the compound may contain an unavoidable impurity element. Specific examples of the compound represented by the aforementioned formula (8) include $Ba_3Nb_5O_{15}$, $Ba_2KNb_5O_{15}$, and $Ba_2NaNb_5O_{15}$. Also, the secondary phase may further include another compound such as a spinel compound, so long as variation in characteristics of the secondary phase achieved through inclusion of a compound having a tungsten bronze-type structure fall within an allowable range,

The compound having a tungsten bronze-type structure and forming the aforementioned secondary phase have no piezoelectric property. However, when the compound is co-present with the primary phase formed of an alkali niobate-based perovskite oxide, sinterability of the piezoelectric composition and stability of the structure are enhanced, to thereby achieve enhanced piezoelectric characteristics. From the viewpoint of securing the effect of enhancing sinterability of the lead-free piezoelectric composition, the relative amount of the secondary phase is preferably adjusted to 0.3 vol% or more, more preferably 0.5 vol% or more. Also, from the viewpoint of securing the effect of enhancing piezoelectric characteristics of the lead-free piezoelectric composition, the relative amount of the secondary phase is preferably adjusted to 10 vol% or less, more preferably 7 vol% or less. Notably, whether or not the compound forming the secondary phase is a compound having a tungsten bronze-type structure may be determined through a Rietveld analysis employing the results of powder X-ray diffraction (XRD).

As also mentioned above, the secondary phase of the lead-free piezoelectric composition of the present embodiment satisfies at least one condition among three conditions in relation to 80% cumulative frequency grain size (D80), 50% cumulative frequency grain size (D50), and 20% cumulative frequency grain size (D20), in a volume-based grain size distribution, represented by the following numerical expressions (1) to (3).

$$1.3 \; \mu m \leq D80 \leq 218.6 \; \mu m \quad \cdots \quad (1)$$

$$0.4 \; \mu m \leq D50 \leq 68.7 \; \mu m \quad \cdots \quad (2)$$

$$0.1 \; \mu m \leq D20 \leq 22.2 \; \mu m \quad \cdots \quad (3)$$

The D80, D50, and D20 may be determined through the following procedure. Specifically, a sintered body of the target lead-free piezoelectric composition is mirror-polished and subjected to an electric conduction treatment. Then, a backscattered electron image ($\times$500 to 3,000) of the sintered body is taken by means of an electron probe micro-analyzer (EPMA). The thus-obtained backscattered electron image is binarized by image analysis software, to thereby divide the image to a primary phase and a secondary phase. Then, a circle-equivalent grain diameter is calculated from the area of each grain observed in the secondary phase, to thereby obtaine the aforementioned D80, D50, and D20.

In the secondary phase of the lead-free piezoelectric composition of the present embodiment, preferably, the 80% cumulative frequency grain size (D80) in the volume-based grain size distribution satisfies the aforementioned numerical expression (1) and further satisfies the following numerical expression (4). According to the above technical feature, a higher mechanical quality factor Qm and a lower dielectric loss tan$\delta$ of the lead-free piezoelectric composition can be achieved.

$$1.3 \; \mu m \leq D80 \leq 155.2 \; \mu m \quad \cdots \quad (4)$$

Also, in the secondary phase of the lead-free piezoelectric composition of the present embodiment, preferably, the 50% cumulative frequency grain size (D50) in the volume-based grain size distribution satisfies the aforementioned numerical expression (2) and further satisfies the following numerical expression (5). According to the above technical feature, a higher mechanical quality factor Qm and a lower dielectric loss tan$\delta$ of the lead-free piezoelectric composition can be achieved.

$$0.4\ \mu m \leq D50 \leq 60.7\ \mu m \quad \cdots \quad (5)$$

Also, in the secondary phase of the lead-free piezoelectric composition of the present embodiment, preferably, the 20% cumulative frequency grain size (D20) in the volume-based grain size distribution satisfies the aforementioned numerical expression (3) and further satisfies the following numerical expression (5). According to the above technical feature, a higher mechanical quality factor Qm and a lower dielectric loss $\tan\delta$ of the lead-free piezoelectric composition can be achieved.

$$0.1\ \mu m \leq D20 \leq 6.7 \mu m \quad \cdots \quad (6)$$

B. Piezoelectric element:

(B-1) Structure of piezoelectric element:

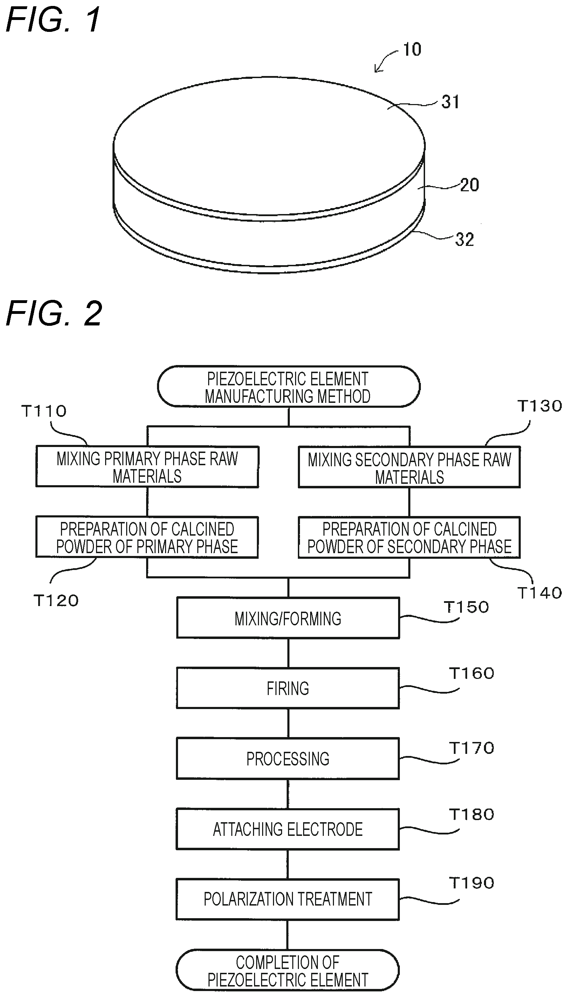

FIG. 1 is a perspective view of an appearance of a piezoelectric element 10 according to the present embodiment. The piezoelectric element 10 has a piezoelectric body 20 formed of the lead-free piezoelectric composition of the present embodiment and electrodes 31 and 32. The piezoelectric element 10 has a configuration in which the electrodes 31 and 32 are attached to the top and bottom surfaces of the disk-shape piezoelectric body 20, respectively. Notably, the piezoelectric element may be formed as a piezoelectric element having different shapes and configurations.

(B-2) Method of manufacturing piezoelectric element:

FIG. 2 is a flowchart showing an example of a method of manufacturing the piezoelectric element 10. In manufacturing of the piezoelectric element 10, firstly, raw materials of the primary phase of the lead-free piezoelectric composition are mixed (step T110). In this step, powder-form raw materials required for forming the primary phase are selected and weighed so as to achieve a target compositional proportions. The powder-form raw materials may be an oxide, a carbonate salt, or a hydroxide of elements contained in the alkali niobate-based perovskite oxide forming the primary phase. Specific examples of suitable raw materials include $K_2CO_3$ powder, $Na_2CO_3$ powder, $Li_2CO_3$ powder, $CaCO_3$ powder, $SrCO_3$ powder, $BaCO_3$ powder, $Nb_2O_5$ powder, $TiO_2$ powder, and $ZrO_2$ powder. In step T110, ethanol is added to the aforementioned powder raw materials, and the mixture is subjected to wet-mixing by means of a ball mill for, preferably, 15 hours or longer, to thereby prepare a slurry. Then, the slurry is dried to form a mixture powder, which is calcined under conditions, for example, in air at 600 to 1,000°C for 1 to 10 hours, to thereby prepare a powder of calcined materials (hereinafter may also be referred to as "calcined powder) of the primary phase (step T120).

In the above description, mixing of powder raw materials in step T110 and calcination in step T120 are conducted to prepare a calcined powder. However, another combination may also be employed. For example, a step of mixing powder raw materials and firing may be repeatedly conducted a plurality of times. More specifically, firstly, powder raw materials including a part of the elements (a plurality of elements) included in a target alkali niobate-based perovskite oxide are mixed and calcined, to thereby yield a calcined powder 1. Then, the thus-obtained calcined powder 1 is mixed with powder raw materials including the remaining elements included in the target alkali niobate-based perovskite oxide, and the resultant mixture is calcined. That is an alternative procedure for preparing a calcined powder of the primary phase.

Separate from the aforementioned step T110, mixing of raw materials of the secondary phase of the lead-free piezoelectric composition is conducted (step T130). In this step, raw powder-form raw materials required for forming the secondary phase are selected and weighed so as to achieve a target compositional proportions. The powder-form raw materials may be an oxide, a carbonate salt, or a hydroxide of elements contained in the compound having a tungsten bronze-type structure and forming the secondary phase. More specifically, raw materials are chosen in accordance with need from $BaCO_3$ powder, $CaCO_3$ powder, $SrCO_3$ powder, $Na_2CO_3$ powder, $K_2CO_3$ powder, $Nb_2O_5$ powder, etc., and weighed. Then, ethanol is added to the powder raw materials, and the mixture is subjected to wet-mixing by means of a ball mill, to thereby prepare a slurry. Wet-mixing with a ball mill is conducted preferably for 15 hours or longer. Subsequently, the slurry is dried to form a mixture powder, which is calcined under conditions, for example, in air at 600 to 1,300°C for 1 to 10 hours, to thereby prepare a calcined powder of the secondary phase (step T140). In step T140, the particle size or particle size distribution of the calcined powder of the secondary phase can be regulated by tuning the calcination temperature. As a result, the grain size and grain size distribution (e.g., D80, D50, or D20) the secondary phase in the lead-free piezoelectric composition can be controlled.

Thereafter, the calcined powder of the primary phase obtained in step T120 and the calcined powder of the secondary phase obtained in step T140 were respectively weighed, and a binder and ethanol are added to the powders.

The powder mixture was subjected to wet-mixing by means of a ball mill, to thereby prepare a slurry. The slurry is subjected to drying, granulation, and shaping (step T150). In a specific procedure, the granulated product is monoaxially pressed at a pressure of 20 MPa, to thereby form a compact having a shape of interest, and the compact is subjected to a CIP treatment (cold isostatic press treatment) at a pressure of, for example, 150 MPa. The CIP body is maintained for firing under conditions, for example, in air at 900 to 1,300°C for 5 hours, to thereby yield a piezoelectric body (step T160). In addition to the aforementioned particle size and particle size distribution of the calcined powder of the secondary phase, the grain size or grain size distribution of the secondary phase of the lead-free piezoelectric composition can be regulated by the firing temperature in step T160.

Next, the piezoelectric body obtained in step T160 is cut in accordance with a dimensional precision required for the piezoelectric element 10, and the upper surface and the bottom surface are processed. The thus-obtained piezoelectric body is annealed in air at 100°C for 2 hours so as to stabilize the characteristics thereof (step T170). Thereafter, electrodes are attached to the surfaces of the piezoelectric body (step T180), and the product is subjected to polarization treatment (step T190), to thereby complete manufacturing of the piezoelectric element 10.

Notably, the aforementioned manufacturing method is merely an example, and many other steps and treatment conditions for manufacturing the piezoelectric element 10 may be employed. For example, instead of separately forming calcined products of the primary phase and the secondary phase, mixing them, and firing, there may be employed an alternative way in which raw materials are mixed at proportions in accordance with the final composition of the lead-free piezoelectric composition, and the mixture is fired. However, when there is employed the method including separately forming calcined products of the primary phase and the secondary phase and mixing them, the compositional ratio of the primary phase to the secondary phase can be more rigorously controlled, whereby the yield of the lead-free piezoelectric composition can be enhanced.

C. Devices employing piezoelectric element:

The piezoelectric element 10 may be suitably used in the following devices. Examples of such a device include an ultrasonic surgical knife 40, an ultrasonic scaler 50, an ultrasonic cleaning machine 60, an ultrasonic processing machine 70, a piezoelectric transducer 80, an ultrasonic motor 90, a piezoelectric gyro sensor 100, a piezoelectric filter 110, and a knock sensor 120.

(C-1) Ultrasonic surgical knife

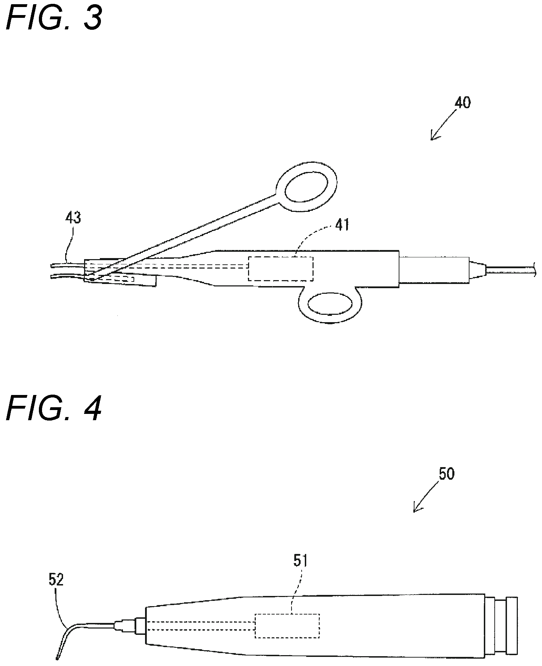

FIG. 3 is a schematic view of an ultrasonic surgical knife 40, which is one embodiment of the present disclosure. The ultrasonic surgical knife 40 has an ultrasonic vibrator 41 and a working member 43. The ultrasonic vibrator 41 has the aforementioned piezoelectric element 10. When an electric signal is applied to the vibrator, the vibrator works to generate ultrasonic vibration. The ultrasonic vibrator 41 is operationally adapted to transfer ultrasonic vibration to the working member 43 in an axial form. The ultrasonic vibrator 41 drives the working member 43 such that a biomedical tissue is cut or peeled, or antibleeding action is provided via thermocoagulation, in the vicinity of the working member 43.

(C-2) Ultrasonic scaler

FIG. 4 is a schematic view of an ultrasonic scaler 50, which is one embodiment of the present disclosure. The ultrasonic scaler 50 is a dental medical instrument for crushing tartar and stain deposited on teeth by ultrasonic vibration for cleaning. The ultrasonic scaler 50 has an ultrasonic vibrator 51 and a dental chip 52. The ultrasonic vibrator 51 has the aforementioned piezoelectric element 10. When an electric signal is applied to the vibrator, the vibrator works to generate ultrasonic vibration. The ultrasonic vibrator 51 is operationally adapted to transfer ultrasonic vibration to the dental chip 52.

(C-3) Ultrasonic cleaning machine

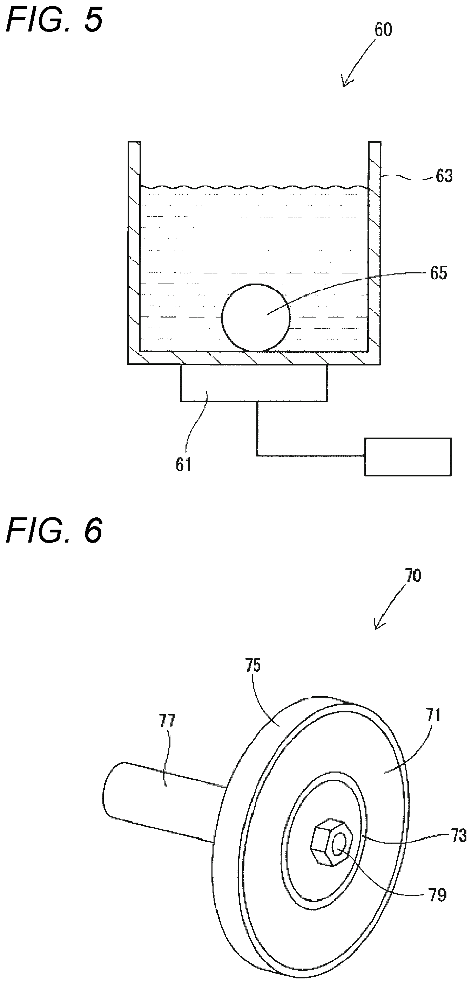

FIG. 5 is a schematic view of an ultrasonic cleaning machine 60, which is one embodiment of the present disclosure. The ultrasonic cleaning machine 60 has an ultrasonic vibrator 61 and a cleaning container 63. The ultrasonic vibrator 61 has the aforementioned piezoelectric element 10. When an electric signal is applied to the vibrator, the vibrator works to generate ultrasonic vibration. When a cleaning object 65 is placed in the cleaning container 63 accommodating a cleaning liquid, and the ultrasonic vibrator 61 generates vibration, the generated ultrasonic vibration is transferred to the cleaning liquid, whereby the cleaning object 65 is cleaned.

(C-4) Ultrasonic processing machine

FIG. 6 is a schematic view of an ultrasonic processing machine 70, which is one embodiment of the present disclosure. The ultrasonic processing machine 70 has a substrate 71, an ultrasonic vibrator 73, a whetstone part 75, a spindle 77, and a fitting jig 79. The substrate 71 has a disk shape, and a whetstone part 75 is disposed around the circumference of the substrate 71. The center of the substrate 71 is fixed to the spindle 77.

The ultrasonic vibrator 73 has the aforementioned piezoelectric element 10. When an electric signal is applied to the vibrator, the vibrator works to generate ultrasonic vibration. The driving direction of the ultrasonic vibrator 73 corresponds to a radial direction from the center of the substrate 71 to the circumference. While the ultrasonic vibrator 73 generates vibration, the spindle 77 is rotated about the axis line thereof. In this state, when the a whetstone part 75 disposed around the circumference of the substrate 71 is caused to abut a processing target, the target can be cut.

(C-5) Piezoelectric transducer

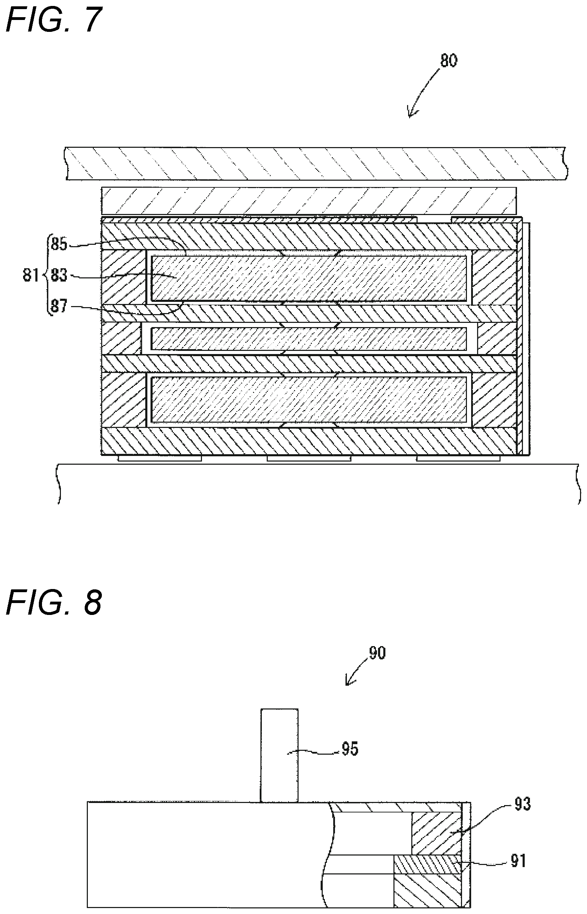

FIG. 7 is a schematic view of a piezoelectric transducer 80, which is one embodiment of the present disclosure. The piezoelectric transducer 80 is an electromechanical energy conversion device that can convert an electric signal to mechanical displacement. The piezoelectric transducer 80 has a piezoelectric element 81. The piezoelectric element 81 has the same configuration as that of the aforementioned piezoelectric element 10. The piezoelectric element 81 has a lead-free piezoelectric member 83, and electrodes 85 and 87 attached to respective surfaces of the lead-free piezoelectric member 83.

(C-6) Ultrasonic motor

FIG. 8 is a schematic view of an ultrasonic motor 90, which is one embodiment of the present disclosure. The ultrasonic motor 90 has an ultrasonic vibrator 91, a rotor 93, and an output axis 95. The ultrasonic vibrator 91 has the aforementioned piezoelectric element 10. The ultrasonic motor 90 is an actuator that can convert an intrinsic vibration generated by the ultrasonic vibrator 91 to a rotational motion or the like of the rotor 93 via frictional force. For example, when an AC voltage is applied to the piezoelectric element 10, a flexural travelling wave is generated at the ultrasonic vibrator 91, and points on the sliding surface of the ultrasonic vibrator 91 are involved in elliptic motion. When the rotor 93 is pressed onto the sliding surface of the ultrasonic vibrator 91, the rotor 93 receives friction force from the ultrasonic vibrator 91 and rotates in a direction opposite to the direction of the flexural travelling wave.

(C-7) Piezoelectric gyro sensor

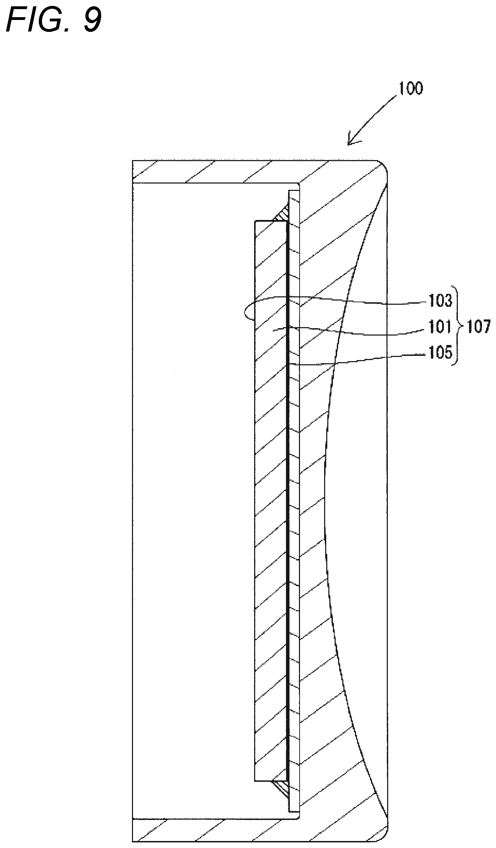

FIG. 9 is a schematic view of a piezoelectric gyro sensor 100, which is one embodiment of the present disclosure. The piezoelectric gyro sensor 100 is a device that can detect an angular velocity through Coriolis force generated at a vibrator. The piezoelectric gyro sensor 100 has a lead-free piezoelectric member 101, and a piezoelectric element 107 having electrodes 103 and 105 applied onto respective surfaces of the lead-free piezoelectric member 101. The piezoelectric element 107 has the same configuration as that of the aforementioned piezoelectric element 10.

(C-8) Piezoelectric filter

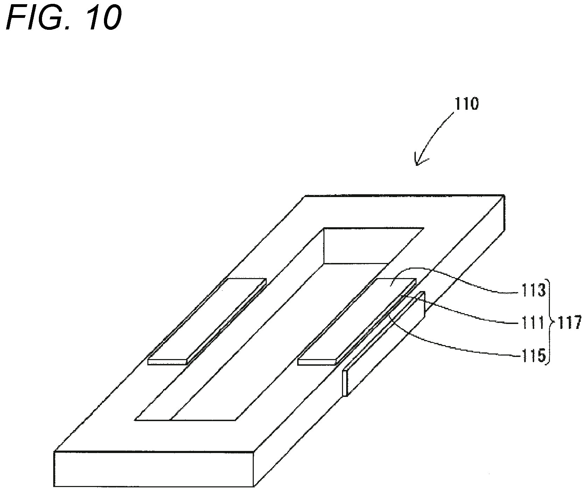

FIG. 10 is a schematic view of a stacked type piezoelectric filter 110, which is one embodiment of the present disclosure. The piezoelectric filter 110 is a device that can receive an electric signal within a specific frequency range by exciting an elastic wave. The stacked type piezoelectric filter 110 has a columnar lead-free piezoelectric member 111, and a piezoelectric element 117 equipped with electrodes 113 and 115 disposed on respective surfaces of the lead-free piezoelectric member 111. The piezoelectric element 117 has the same configuration as that of the aforementioned piezoelectric element 10.

(C-9) Knock sensor

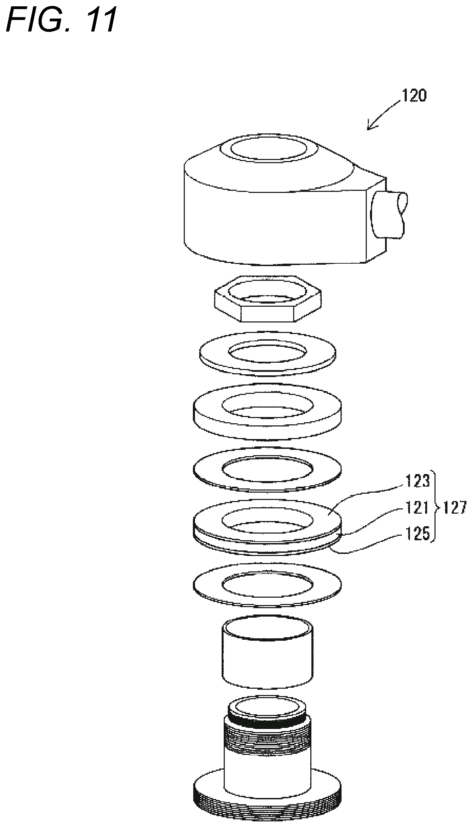

FIG. 11 is a schematic view of a knock sensor 120, which is one embodiment of the present disclosure. The knock sensor 120 is a device that is attached to, for example, an engine block and can detect knocking by converting, to an electric signal, force attributed to vibration of the engine block caused by knocking. The knock sensor 120 has a lead-free piezoelectric member 121, and a piezoelectric element 127 equipped with electrodes 123 and 125. The piezoelectric element 127 has the same configuration as that of the aforementioned piezoelectric element 10.

According to the lead-free piezoelectric composition of the present embodiment manufactured in the aforementioned manner, the lead-free piezoelectric composition having a primary phase formed of the alkali niobate-based perovskite oxide includes the aforementioned secondary phase containing a compound having a tungsten bronze-type structure, to thereby provide an enhanced sinterability. In addition, the secondary phase satisfies at least one condition among three conditions in relation to grain size-related D80, D50, and D20 represented by the aforementioned numerical expressions (1) to (3), whereby the mechanical quality factor Qm of the lead-free piezoelectric composition can be enhanced, and the dielectric loss tan$\delta$ thereof can be reduced.

EXAMPLE

Twenty-seven samples of the lead-free piezoelectric composition; i.e., samples S1 to S27, having different features of the primary phase and the secondary phase were prepared. Mechanical quality factor Qm and dielectric loss tan$\delta$ of the samples were assessed.

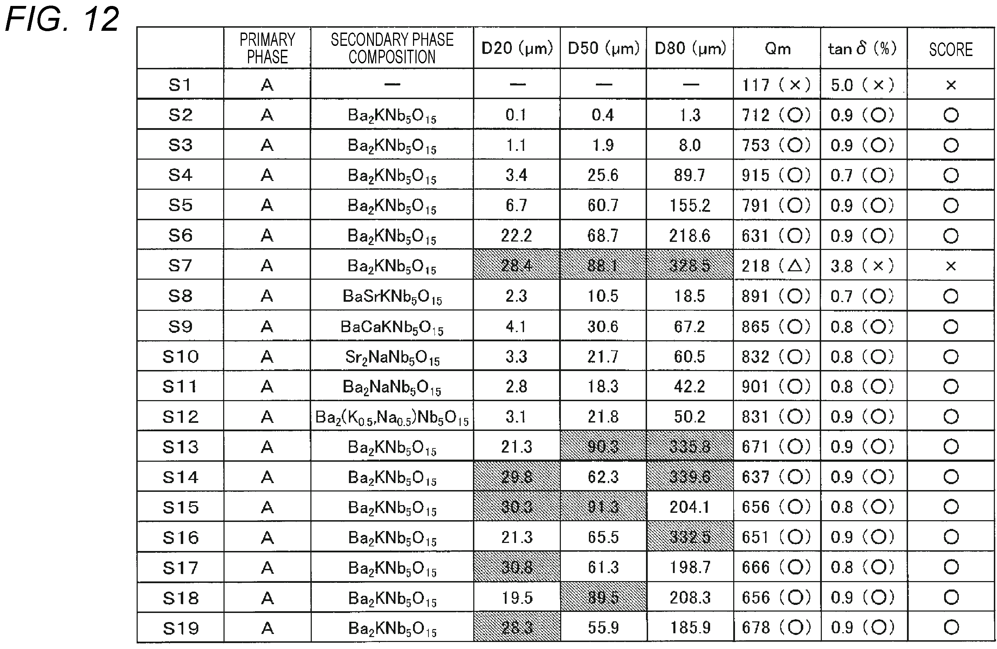

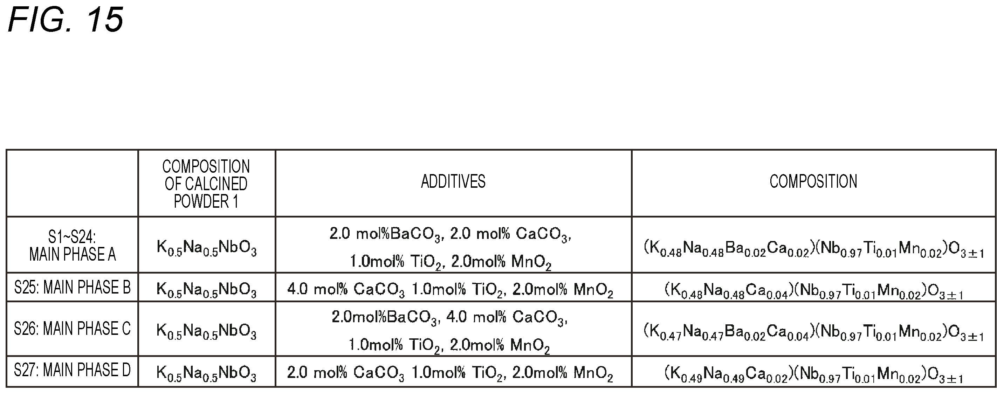

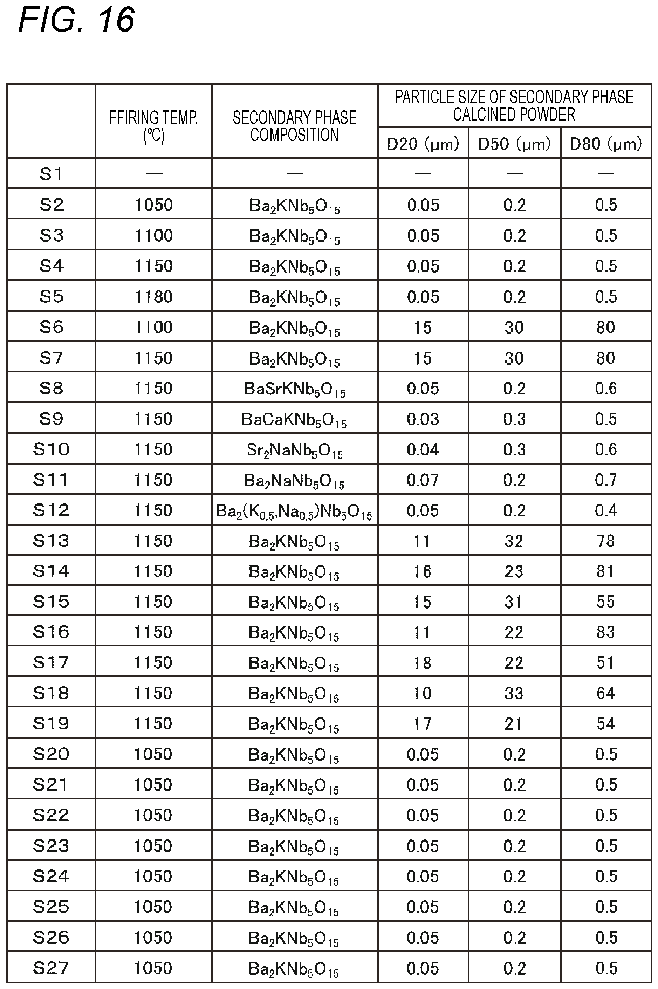

FIGs. 12 to 14 are tables each collectively showing features of samples and results of evaluation. FIG. 15 is a table showing features of the primary phase of each sample. FIG. 16 is a table showing features of calcined powders for forming the secondary phase.

<Production of lead-free piezoelectric composition>

[Sample S1]

A lead-free piezoelectric composition formed of a primary phase and including no secondary phase was produced as sample S1. In FIG. 2, there are described step T110 including mixing of powder raw materials of the calcined powder for forming the primary phase, and step T120 including calcining the mixed raw materials. In the Example, a part of the powder raw materials of the primary phase was mixed and then calcined, to thereby prepare a calcined powder 1. Subsequently, the remaining of the raw material powders was added to the calcined powder 1 under mixing, and the mixture was calcined, to thereby prepare a calcined powder 2 serving as a calcined powder of the primary phase. In preparation of the calcined powder 1, $K_2CO_3$ powder, $Na_2CO_3$ powder, and $Nb_2O_5$ powder were used as powders of raw material, and weighed in accordance with "COMPOSITION OF CALCINED POWDER 1" shown in FIG. 15. Ethanol was added to the thus-weighed powder raw materials, and the mixture was subjected to wet-mixing by means of a ball mill for 15 hours, to thereby prepare a slurry. Thereafter, the slurry was dried to provide a powder mixture, which was calcined at 600 to 1,100°C in air for 1 to 10 hours, to thereby yield the calcined powder 1.

To the thus-obtained calcined powder 1, additives of sample S1 having a composition shown in FIG. 15 were added at proportions shown in FIG. 15. The amount of each additive shown in FIG. 15 refers to a relative amount with respect to the amount of the calcined powder 1 (target of addition) as 100 mol%. Then, ethanol was added to the powder raw materials containing the additives, and the resultant mixture was subjected to wet-mixing by means of a ball mill for 15 hours, to thereby prepare a slurry. Thereafter, the slurry was dried to provide a powder mixture, which was calcined at 600 to 1,100°C in air for 1 to 10 hours, to thereby yield the calcined powder 2, serving as the calcined powder of the primary phase.

To the calcined powder 2, ethanol and a binder were added, and the mixture was subjected to wet-mixing by means of a ball mill, to thereby prepare a slurry. Subsequently, the slurry was dried, granulated, and monoaxially pressed at a pressure of 20 MPa, to thereby form a compact of a shape of interest. Then, the compact was subjected to a CIP treatment at a pressure of 150 MPa, to thereby yield a subsequent compact (corresponding to step T150). The thus-obtained compact was fired in air at 900°C to 1,300°C for 1 to 10 hours (corresponding to step T160), to thereby yield a lead-free piezoelectric composition (piezoelectric body) as sample S1. The compositional proportions of the primary phase of the thus-obtained sample S1 are shown in FIG. 15. Notably, the primary phase of each of sample S1 and the below-mentioned samples S2 to S24 may also be referred to as "primary phase A" (see FIGs. 12 to 15).

[Samples S2 to S7]

Lead-free piezoelectric compositions each having the same primary phase as that of sample S1 (i.e., primary phase A) and a secondary phase including a compound having a tungsten bronze-type structure and represented by $Ba_2KNb_5O_{15}$ were prepared as samples S2 to S7 (see FIG. 12). The calcined powder for forming the primary phase was produced in the same manner as employed in the case of the calcined powder 2 mentioned in relation to sample S1.

In preparation of samples S2 to S7, $BaCO_3$ powder, $K_2CO_3$ powder, and $Nb_2O_5$ powder were weighed in accordance with the aforementioned compositional proportions of the secondary phase. Ethanol was added to the thus-weighed powder raw materials, and the mixture was subjected to wet-mixing by means of a ball mill for 15 hours, to thereby prepare a slurry. Thereafter, the slurry was dried to provide a powder mixture, which was calcined at 600 to 1,300°C in air for 1 to 10 hours, to thereby yield the calcined powder of the secondary phase (step T140). Then, the aforementioned calcined powder 2 of the primary phase and the calcined powder of the secondary phase were weighed. Ethanol and a binder were added, the mixture was subjected to wet-mixing by means of a ball mill, to thereby prepare a slurry. Subsequently, the slurry was dried, granulated, and monoaxially pressed at a pressure of 20 MPa, to thereby form a compact of a shape of interest. Then, the compact was subjected to a CIP treatment at a pressure of 150 MPa, to thereby yield a subsequent compact (step T150). The thus-obtained compact was fired in air at 900°C to 1,300°C for 1 to 10 hours (step T160), to thereby yield lead-free piezoelectric compositions (piezoelectric bodies) as samples S2 to S7. Notably, in samples S2 to S7, the secondary phase content (vol%) was constantly adjusted to 1.5 vol%.

In samples S2 to S7, the particle size distribution of the calcined powder of the secondary phase was modified by changing the calcination temperature employed in step T140, and the grain size distribution of the secondary phase of the lead-free piezoelectric composition was modified by changing the firing temperature employed in step T160. Specifically, samples S2 to S5 were produced from a calcined powder yielded at the same calcination temperature (D20=0.05 $\mu$m, D50=0.2 $\mu$m, D80=0.5 $\mu$m), while samples S6 and S7 were produced from a calcined powder yielded at a calcination temperature different from that employed in samples S2 to S5 (D20=15 $\mu$m, D50=30 $\mu$m, D80=80 $\mu$m) (see FIG. 16). The calcined powder of the secondary phase employed in samples S2 to S5 may also be referred to as a "calcined powder $\alpha$," and the calcined powder of the secondary phase employed in samples S6 and S7 may also be referred to as a "calcined powder $\beta$." Notably, the particle size of the calcined powder of the secondary phase employed in each sample shown in FIG. 16 was measured by means of a laser diffraction/scattering particle size distribution meter (LA-750, product of HORIBA Co., Ltd.). In step T160, samples S2 to S7 were produced at a firing temperature shown in FIG. 16.

[Samples S8 to S12]

Lead-free piezoelectric compositions (piezoelectric bodies) each having the same primary phase as that of sample S2 (i.e., primary phase A) and a secondary phase formed of a compound having a tungsten bronze-type structure and having compositional proportions different from those of sample S2 were prepared as samples S8 to S12 (see FIG. 12). In preparation of sample S8, BaCO$_3$ powder, SrCO$_3$ powder, K$_2$CO$_3$ powder, and Nb$_2$O$_5$ powder were used as powder raw materials of the secondary phase. In preparation of sample S9, BaCO$_3$ powder, CaCO$_3$ powder, K$_2$CO$_3$ powder, and Nb$_2$O$_5$ powder were used as powder raw materials of the secondary phase. In preparation of sample S10, SrCO$_3$ powder, Na$_2$CO$_3$ powder, and Nb$_2$O$_5$ powder were used as powder raw materials of the secondary phase. In preparation of sample S11, BaCO$_3$ powder, Na$_2$CO$_3$ powder, and Nb$_2$O$_5$ powder were used as powder raw materials of the secondary phase. In preparation of sample S12, BaCO$_3$ powder, Na$_2$CO$_3$ powder, K$_2$CO$_3$ powder, and Nb$_2$O$_5$ powder were used as powder raw materials of the secondary phase. In each case of samples S8 to S12, the calcined powder of the secondary phase was prepared at compositional proportions and particle size shown in FIG. 16. Samples S8 to S12 were prepared under the same conditions as employed in preparation of sample S2, except that different compositional proportions of the calcined powder of the secondary phase were employed. Also in samples S8 to S12, the secondary phase content (vol%) was constantly adjusted to 1.5 vol%.

[Samples S13 to S19]

Lead-free piezoelectric compositions (piezoelectric bodies) each having the same primary phase as that of sample S2 (i.e., primary phase A) and a secondary phase formed of a compound having a tungsten bronze-type structure and having the compositional proportions the same as those of S2, but having a particle size of the calcined powder of the secondary phase size different from that of sample S2 were prepared as samples S13 to S19 (see FIGs. 12 and 16). In samples S13 to S19, the calcined powder $\beta$ employed in samples S6 and S7 was classified so as to adjust the particle size distribution of the calcined powder for forming the secondary phase. Samples S13 to S19 were prepared under the same conditions as employed in preparation of sample S2, except that the particle size distribution of the calcined powder of the secondary phase was varied, and the firing temperature in step T160 was 1,150°C. Also in samples S13 to S19, the secondary phase content (vol%) was constantly adjusted to 1.5 vol%.

[Samples S20 to S24]

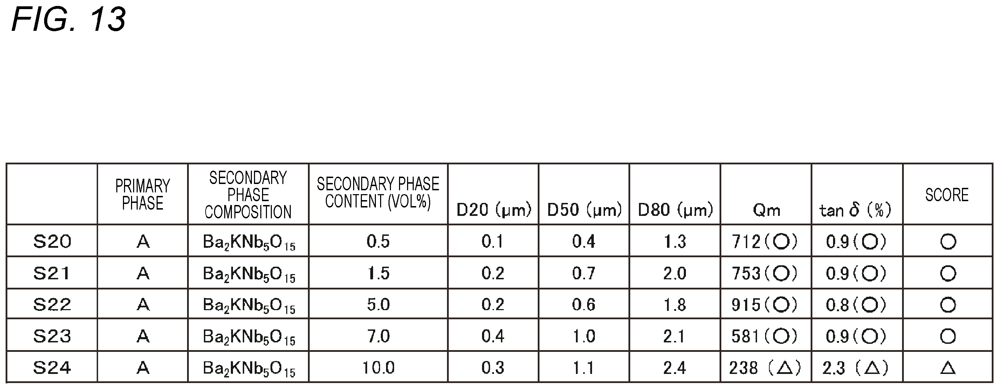

Lead-free piezoelectric compositions (piezoelectric bodies) each having the same primary phase as that of sample S2 (i.e., primary phase A) and a secondary phase formed from the calcined powder $\alpha$ and having the same compositional proportions as that of sample S2 but a different secondary phase content were prepared as samples S20 to S24 (see FIGs. 13 and 16). The secondary phase content (vol%) of each of samples S20 to S24 is represented by "SECONDARY PHASE CONTENT" in FIG. 13. Samples S20 to S24 were prepared under the same conditions as employed in preparation of sample S2.

[Samples S25 to S27]

Lead-free piezoelectric compositions (piezoelectric bodies) each having the same secondary phase as that of sample S2 and a primary phase having compositional proportions different from those of sample S2 were prepared as samples S25 to S27 (see FIGs. 15 and 16). As shown in FIG. 15, in samples S25 to S27, the same calcined powder 1 as employed in sample S2 was used for preparing the calcined powder of the primary phase, but the type and amounts of the additives added to the calcined powder 1 for preparing the calcined powder 2 were varied. As a result, the compositional proportions of the primary phase were varied. Samples S25 to S27 were prepared under the same conditions as employed in preparation of sample S2, except that the type and amounts of the additives added to the calcined powder 1 were different. Also in samples S25 to S27, the secondary phase content (vol%) was constantly adjusted to 1.5 vol%.

<Method of evaluating mechanical quality factor Qm and dielectric loss tanδ>

Each sample was analyzed by means of an impedance analyzer ( E4990A, product of Keysight Technologies), to thereby calculate tanδ at room temperature and 1 kHz. Also, mechanical quality factor Qm was determined through a resonance/anti-resonance method. The mechanical quality factor Qm was evaluated by the ratings "O" (500 or greater), "Δ" (200 or greater and smaller than 500), and "X" (smaller than 200) (see FIGs. 12 to 14). The dielectric loss tanδ was evaluated by the ratings "O" (1.0% or lower), "Δ" (1.5% or higher and 2.5% or lower), and "X" (higher than 2.5%) (see FIGs. 12 to 14).

<Method of calculating grain size of secondary phase and secondary phase content (vol%)>

A sintered body of each sample was mirror-polished and subjected to an electric conduction treatment. Then, a backscattered electron image ($\times$500 to 3,000) of the sintered body was taken by means of an electron probe micro-analyzer (EPMA). In the image analysis, the obtained backscattered electron image was binarized by image analysis software, to thereby divide the image to a primary phase and a secondary phase. Then, a circle-equivalent grain diameter was calculated from the area of each grain observed in the secondary phase, to thereby obtaine D80, D50, and D20 (see FIGs. 12 to 14). Also, after binarization of the backscattered electron image by image analysis software, to thereby divide the image to a primary phase and a secondary phase in the above manner, the secondary phase content (vol%) was calculated from the ratio of the obtained area of the secondary phase to that of the primary phase.

<Method of analyzing each phase>

The element proportions of the primary phase and the secondary phase in each sample were determined by means of EPMA-WDS (wavelength dispersive spectrometer) EPMA-EDS (energy dispersive spectrometer). In addition, whether or not the secondary phase of each sample was a tungsten bronze-type compound was determined through a Rietveld analysis employing the results of powder X-ray diffraction (XRD).

<Evaluation results>

In FIGs. 12 to 14, general evaluation results of each sample are shown in the column of "SCORE." When at least one of evaluation of mechanical quality factor Qm and that of dielectric loss tanδ was "X," the general score was rated with "X." Among the remaining samples not rated with "X" in the general score, a sample having "Δ" of at least one of evaluation of mechanical quality factor Qm and that of dielectric loss tanδ was rated with "Δ" in the general score. Further, among the remaining samples, a sample having "O" of both evaluation of mechanical quality factor Qm and that of dielectric loss tanδ was rated with "O" in the general score.

As shown in FIGs. 12 to 14, the lead-free piezoelectric composition includes a primary phase formed of an alkali niobate-based perovskite oxide, and a secondary phase containing a compound which has a tungsten bronze-type structure including Nb and at least one species selected from among Ba, Ca, Sr, Na, and K, and the secondary phase satisfies at least one condition among three conditions of D80, D50, and D20 in relation to the grain size distribution of the second phase represented by the aforementioned numerical expressions (1) to (3). As a result, the effects of enhancing the mechanical quality factor Qm of the lead-free piezoelectric composition and reducing the dielectric loss tanδ thereof were confirmed (with comparison of samples S2 to S6 and S8 to S27 with samples S1 and S7). Notably, sample S1 having no secondary phase and sample S7 not satisfying any of the three of the aforementioned numerical expressions (1) to (3) were rated by the score of "X" in terms of dielectric loss tanδ. However, sample S1 having no secondary phase had a density (i.e., sinterability) inferior to that of sample S7 including a secondary phase, resulting in an instable microstructural tissue. Thus, conceivably, dielectric loss tanδ increased.

More specifically, in the cases of not only samples S2-S6 satisfying D80, D50, and D20 in relation to the grain size distribution of the second phase represented by the aforementioned numerical expressions (1) to (3), but also samples S13 to S19 having at least one of D80, D50, and D20 satisfying the numerical expressions (1) to (3), the effects of enhancing the mechanical quality factor Qm and reducing the dielectric loss tanδ were confirmed, as compared with sample S7 having D80, D50, and D20 all unsatisfying the numerical formulas (1) to (3). Notably, in FIGs. 12 to 14, the case where D80, D50, or D20 did not satisfy the aforementioned numerical formulas (1) to (3) is denoted with hatching.

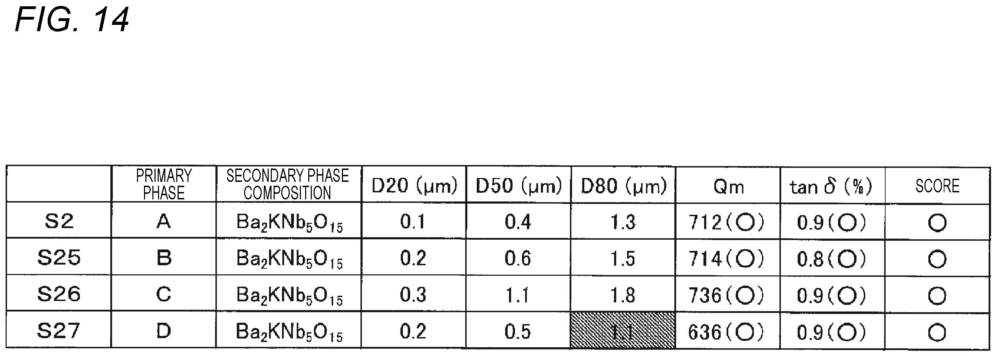

Also, as in the cases of samples S8 to S12, when the conditions of the numerical formulas (1) to (3) in relation to the secondary phase were satisfied, the same effects of enhancing the mechanical quality factor Qm and reducing the dielectric loss tanδ were confirmed, even if the compositional proportions of the secondary phase were varied in many ways. Also, as shown in the cases of samples S20 to S24, even when the secondary phase content was varied within a range, for example, 0.5 to 10.0 vol%, the same effects of enhancing the mechanical quality factor Qm and reducing the dielectric loss tanδ were successfully achieved (see FIG. 13). Particularly when the secondary phase content was adjusted to 0.5 to 7.0 vol%, the effects of enhancing the mechanical quality factor Qm and reducing the dielectric loss tanδ were found to be enhanced. Further, as shown in the cases of samples S2 and S25 to S27, even when the compositional proportions of the alkali niobate-based perovskite oxide forming the primary phase and exhibiting piezoelectricity were varied in many ways, the same effects of enhancing the mechanical quality factor Qm and reducing the dielectric loss tanδ were confirmed to be attained (see FIG. 14).

The present disclosure should not be limited to the aforementioned embodiments and the like and may be carried out in various features, so long as they do not deviate from the gist thereof. For example, technical features residing in the embodiments which features correspond to those residing in the aspects described in the column of SUMMARY OF INVENTION may be appropriately changed or combined, so as to partially or totally solve the aforementioned problems, or partially or totally accomplish the aforementioned effects. Unless the technical features are described as essential elements in the present specification, they may be appropriately discarded.

The present disclosure may be carried out as the following embodiments.

[Application Example 1]

A lead-free piezoelectric composition characterized by including

a primary phase formed of an alkali niobate-based perovskite oxide, and
a secondary phase containing a compound which has a tungsten bronze-type structure including niobium (Nb) and at least one species selected from among barium (Ba), calcium (Ca), strontium (Sr), sodium (Na), and potassium (K), in which
the secondary phase satisfies at least one condition among three conditions in relation to a 80% cumulative frequency grain size (D80), a 50% cumulative frequency grain size (D50), and a 20% cumulative frequency grain size (D20), in a volume-based grain size distribution, represented by the following numerical expressions (1) to (3):

$$1.3 \ \mu m \leq D80 \leq 218.6 \ \mu m \quad \cdots \quad (1),$$

$$0.4 \ \mu m \leq D50 \leq 68.7 \ \mu m \quad \cdots \quad (2),$$

and

$$0.1 \ \mu m \leq D20 \leq 22.2 \ \mu m \quad \cdots \quad (3).$$

[Application Example 2]

The lead-free piezoelectric composition according to Application Example 1, in which,
in the secondary phase, the 80% cumulative frequency grain size (D80) in the volume-based grain size distribution satisfies the aforementioned numerical expression (1) and further satisfies the following numerical expression (4):

$$1.3 \ \mu m \leq D80 \leq 155.2 \ \mu m \quad \cdots \quad (4).$$

[Application Example 3]

The lead-free piezoelectric composition according to Application Example 1 or 2, in which,
in the secondary phase, the 50% cumulative frequency grain size (D50) in the volume-based grain size distribution satisfies the aforementioned numerical expression (2) and further satisfies the following numerical expression (5):

$$0.4 \ \mu m \leq D50 \leq 60.7 \ \mu m \quad \cdots \quad (5).$$

[Application Example 4]

The lead-free piezoelectric composition according to any one of Application Examples 1 to 3, in which, in the secondary phase, the 20% cumulative frequency grain size (D20) in the volume-based grain size distribution satisfies the aforementioned numerical expression (3) and further satisfies the following numerical expression (6):

$$0.1\ \mu m \leq D20 \leq 6.7 \mu m \quad \cdots \quad (6).$$

[Application Example 5]

The lead-free piezoelectric composition according to any one of Application Examples 1 to 4, in which, the alkali niobate-based perovskite-type oxide forming the primary phase contains manganese (Mn).

[Application Example 6]

The lead-free piezoelectric composition according to any one of Application Examples 1 to 5, in which, the alkali niobate-based perovskite-type oxide forming the primary phase includes a primary phase formed of an alkali niobate-based perovskite-type oxide represented by a compositional formula $(A1_a M1_b)_c (Nb_{d1}, Mn_{d2}, M2_{d3})O_{3+e}$ (in which element A1 represents at least one alkali metal; element M1 represents at least one of Ba, Ca, and Sr; element M2 represents at least one of Ti and Zr; conditions: $0 < a < 1$, $0 < b < 1$, and $a+b=1$ are satisfied; c satisfies a condition: $0.80 < c < 1.10$; conditions: $0 < d1 < 1$, $0 < d2 < 1$, $0 < d3 < 1$, and $d1+d2+d3=1$ are satisfied; and e is a value showing oxygen deficiency or excess), and satisfy a condition: $b/(d2+d3) > 1.0$.

[Application Example 7]

A piezoelectric element characterized by having

a piezoelectric body formed of a lead-free piezoelectric composition as recited in any one of Application Examples 1 to 6, and
an electrode attached to the piezoelectric body.

[Application Example 8]

A device characterized by having an piezoelectric element as recited in Application Example 7.

[Application Example 9]

The device according to Application Example 8, which is any of an ultrasonic surgical knife, an ultrasonic scaler, an ultrasonic cleaning machine, an ultrasonic processing machine, a piezoelectric transducer, an ultrasonic motor, a piezoelectric gyro sensor, a piezoelectric filter, and a knock sensor.

REFERENCE SIGNS LIST

10 piezoelectric element
20 piezoelectric body
31, 32 electrode
40 ultrasonic surgical knife
41 ultrasonic vibrator
43 working member
50 ultrasonic scaler
51 ultrasonic vibrator
52 dental chip
60 ultrasonic cleaning machine
61 ultrasonic vibrator

63 cleaning container
65 cleaning object
70 ultrasonic processing machine
71 substrate
73 ultrasonic vibrator
75 whetstone part
77 spindle
79 fixing jig
80 piezoelectric transducer
81 piezoelectric element
83 lead-free piezoelectric member
85 electrode
90 ultrasonic motor
91 ultrasonic vibrator
93 rotor
95 output axis
100 piezoelectric gyro sensor
101 lead-free piezoelectric member
103 electrode
107 piezoelectric element
110 piezoelectric filter
111 lead-free piezoelectric member
113 electrode
117 piezoelectric element
120 knock sensor
121 lead-free piezoelectric member
123 electrode
127 piezoelectric element

## Claims

1. A lead-free piezoelectric composition **characterized by** comprising

   a primary phase formed of an alkali niobate-based perovskite oxide, and
   a secondary phase containing a compound which has a tungsten bronze-type structure including niobium (Nb) and at least one species selected from among barium (Ba), calcium (Ca), strontium (Sr), sodium (Na), and potassium (K), wherein
   the secondary phase satisfies at least one condition among three conditions in relation to a 80% cumulative frequency grain size (D80), a 50% cumulative frequency grain size (D50), and a 20% cumulative frequency grain size (D20), in a volume-based grain size distribution, represented by the following numerical expressions (1) to (3):

$$1.3\ \mu m \leq D80 \leq 218.6\ \mu m \quad \cdots \quad (1),$$

$$0.4\ \mu m \leq D50 \leq 68.7\ \mu m \quad \cdots \quad (2),$$

   and

$$0.1\ \mu m \leq D20 \leq 22.2\ \mu m \quad \cdots \quad (3).$$

2. The lead-free piezoelectric composition according to claim 1, wherein
   in the secondary phase, the 80% cumulative frequency grain size (D80) in the volume-based grain size distribution satisfies the aforementioned numerical expression (1) and further satisfies the following numerical expression (4):

$$1.3 \ \mu m \leq D80 \leq 155.2 \ \mu m \quad \cdots \quad (4).$$

3. The lead-free piezoelectric composition according to claim 1 or 2, wherein
   in the secondary phase, the 50% cumulative frequency grain size (D50) in the volume-based grain size distribution satisfies the aforementioned numerical expression (2) and further satisfies the following numerical expression (5):

$$0.4 \ \mu m \leq D50 \leq 60.7 \ \mu m \quad \cdots \quad (5).$$

4. The lead-free piezoelectric composition according to any one of claims 1 to 3, wherein
   in the secondary phase, the 20% cumulative frequency grain size (D20) in the volume-based grain size distribution satisfies the aforementioned numerical expression (3) and further satisfies the following numerical expression (6):

$$0.1 \ \mu m \leq D20 \leq 6.7 \mu m \quad \cdots \quad (6).$$

5. The lead-free piezoelectric composition according to any one of claims 1 to 4, wherein
   the alkali niobate-based perovskite-type oxide forming the primary phase contains manganese (Mn).

6. The lead-free piezoelectric composition according to any one of claims 1 to 5, wherein
   the alkali niobate-based perovskite-type oxide forming the primary phase includes a primary phase formed of an alkali niobate-based perovskite-type oxide represented by a compositional formula $(A1_a M1_b)_c (Nb_{d1}, Mn_{d2}, M2_{d3}) O_{3+e}$ (in which element A1 represents at least one alkali metal; element M1 represents at least one of Ba, Ca, and Sr; element M2 represents at least one of Ti and Zr; conditions: $0<a<1$, $0<b<1$, and $a+b=1$ are satisfied; c satisfies a condition: $0.80<c<1.10$; conditions: $0<d1<1$, $0<d2<1$, $0<d3<1$, and $d1+d2+d3=1$ are satisfied; and e is a value showing oxygen deficiency or excess), and satisfy a condition: $b/(d2+d3)>1.0$.

7. A piezoelectric element **characterized by** comprising

   a piezoelectric body formed of a lead-free piezoelectric composition as recited in any one of claims 1 to 6, and an electrode attached to the piezoelectric body.

8. A device **characterized by** comprising a piezoelectric element as recited in claim 7.

9. The device according to claim 8,
   which is any of an ultrasonic surgical knife, an ultrasonic scaler, an ultrasonic cleaning machine, an ultrasonic processing machine, a piezoelectric transducer, an ultrasonic motor, a piezoelectric gyro sensor, a piezoelectric filter, and a knock sensor.

## FIG. 1

## FIG. 2

*FIG. 3*

*FIG. 4*

*FIG. 5*

*FIG. 6*

## FIG. 7

## FIG. 8

*FIG. 9*

*FIG. 10*

# FIG. 11

*FIG. 12*

| | PRIMARY PHASE | SECONDARY PHASE COMPOSITION | D20 (μm) | D50 (μm) | D80 (μm) | Qm | tan δ (%) | SCORE |
|---|---|---|---|---|---|---|---|---|
| S1 | A | — | — | — | — | 117 (×) | 5.0 (×) | × |
| S2 | A | $Ba_2KNb_5O_{15}$ | 0.1 | 0.4 | 1.3 | 712 (○) | 0.9 (○) | ○ |
| S3 | A | $Ba_2KNb_5O_{15}$ | 1.1 | 1.9 | 8.0 | 753 (○) | 0.9 (○) | ○ |
| S4 | A | $Ba_2KNb_5O_{15}$ | 3.4 | 25.6 | 89.7 | 915 (○) | 0.7 (○) | ○ |
| S5 | A | $Ba_2KNb_5O_{15}$ | 6.7 | 60.7 | 155.2 | 791 (○) | 0.9 (○) | ○ |
| S6 | A | $Ba_2KNb_5O_{15}$ | 22.2 | 68.7 | 218.6 | 631 (○) | 0.9 (○) | ○ |
| S7 | A | $Ba_2KNb_5O_{15}$ | 28.4 | 88.1 | 378.5 | 218 (△) | 3.8 (×) | × |
| S8 | A | $BaSrKNb_5O_{15}$ | 2.3 | 10.5 | 18.5 | 891 (○) | 0.7 (○) | ○ |
| S9 | A | $BaCaKNb_5O_{15}$ | 4.1 | 30.6 | 67.2 | 865 (○) | 0.8 (○) | ○ |
| S10 | A | $Sr_2NaNb_5O_{15}$ | 3.3 | 21.7 | 60.5 | 832 (○) | 0.8 (○) | ○ |
| S11 | A | $Ba_2NaNb_5O_{15}$ | 2.8 | 18.3 | 42.2 | 901 (○) | 0.8 (○) | ○ |
| S12 | A | $Ba_2(K_{0.5},Na_{0.5})Nb_5O_{15}$ | 3.1 | 21.8 | 50.2 | 831 (○) | 0.9 (○) | ○ |
| S13 | A | $Ba_2KNb_5O_{15}$ | 21.3 | 90.3 | 335.8 | 671 (○) | 0.9 (○) | ○ |
| S14 | A | $Ba_2KNb_5O_{15}$ | 29.8 | 62.3 | 339.6 | 637 (○) | 0.9 (○) | ○ |
| S15 | A | $Ba_2KNb_5O_{15}$ | 30.3 | 91.3 | 204.1 | 656 (○) | 0.8 (○) | ○ |
| S16 | A | $Ba_2KNb_5O_{15}$ | 21.3 | 65.5 | 332.5 | 651 (○) | 0.9 (○) | ○ |
| S17 | A | $Ba_2KNb_5O_{15}$ | 30.8 | 61.3 | 198.7 | 666 (○) | 0.8 (○) | ○ |
| S18 | A | $Ba_2KNb_5O_{15}$ | 19.5 | 89.5 | 208.3 | 656 (○) | 0.9 (○) | ○ |
| S19 | A | $Ba_2KNb_5O_{15}$ | 28.3 | 55.9 | 185.9 | 678 (○) | 0.9 (○) | ○ |

## FIG. 13

| | PRIMARY PHASE | SECONDARY PHASE COMPOSITION | SECONDARY PHASE CONTENT (VOL%) | D20 (µm) | D50 (µm) | D80 (µm) | Qm | tan $\delta$ (%) | SCORE |
|---|---|---|---|---|---|---|---|---|---|
| S20 | A | $Ba_2KNb_5O_{15}$ | 0.5 | 0.1 | 0.4 | 1.3 | 712(○) | 0.9(○) | ○ |
| S21 | A | $Ba_2KNb_5O_{15}$ | 1.5 | 0.2 | 0.7 | 2.0 | 753(○) | 0.9(○) | ○ |
| S22 | A | $Ba_2KNb_5O_{15}$ | 5.0 | 0.2 | 0.6 | 1.8 | 915(○) | 0.8(○) | ○ |
| S23 | A | $Ba_2KNb_5O_{15}$ | 7.0 | 0.4 | 1.0 | 2.1 | 581(○) | 0.9(○) | ○ |
| S24 | A | $Ba_2KNb_5O_{15}$ | 10.0 | 0.3 | 1.1 | 2.4 | 238 (△) | 2.3 (△) | △ |

# FIG. 14

| | PRIMARY PHASE | SECONDARY PHASE COMPOSITION | D20 (μm) | D50 (μm) | D80 (μm) | Qm | tan δ (%) | SCORE |
|---|---|---|---|---|---|---|---|---|
| S2 | A | $Ba_2KNb_5O_{15}$ | 0.1 | 0.4 | 1.3 | 712 (○) | 0.9 (○) | ○ |
| S25 | B | $Ba_2KNb_5O_{15}$ | 0.2 | 0.6 | 1.5 | 714 (○) | 0.8 (○) | ○ |
| S26 | C | $Ba_2KNb_5O_{15}$ | 0.3 | 1.1 | 1.8 | 736 (○) | 0.9 (○) | ○ |
| S27 | D | $Ba_2KNb_5O_{15}$ | 0.2 | 0.5 | ▨ | 636 (○) | 0.9 (○) | ○ |

## FIG. 15

| | COMPOSITION OF CALCINED POWDER 1 | ADDITIVES | COMPOSITION |
|---|---|---|---|
| S1~S24: MAIN PHASE A | $K_{0.5}Na_{0.5}NbO_3$ | 2.0 mol%$BaCO_3$, 2.0 mol% $CaCO_3$, 1.0mol% $TiO_2$, 2.0mol% $MnO_2$ | $(K_{0.48}Na_{0.48}Ba_{0.02}Ca_{0.02})(Nb_{0.97}Ti_{0.01}Mn_{0.02})O_{3\pm1}$ |
| S25: MAIN PHASE B | $K_{0.5}Na_{0.5}NbO_3$ | 4.0 mol% $CaCO_3$ 1.0mol% $TiO_2$, 2.0mol% $MnO_2$ | $(K_{0.48}Na_{0.48}Ca_{0.04})(Nb_{0.97}Ti_{0.01}Mn_{0.02})O_{3\pm1}$ |
| S26: MAIN PHASE C | $K_{0.5}Na_{0.5}NbO_3$ | 2.0mol%$BaCO_3$, 4.0 mol% $CaCO_3$, 1.0mol% $TiO_2$, 2.0mol% $MnO_2$ | $(K_{0.47}Na_{0.47}Ba_{0.02}Ca_{0.04})(Nb_{0.97}Ti_{0.01}Mn_{0.02})O_{3\pm1}$ |
| S27: MAIN PHASE D | $K_{0.5}Na_{0.5}NbO_3$ | 2.0 mol% $CaCO_3$ 1.0mol% $TiO_2$, 2.0mol% $MnO_2$ | $(K_{0.49}Na_{0.49}Ca_{0.02})(Nb_{0.97}Ti_{0.01}Mn_{0.02})O_{3\pm1}$ |

## FIG. 16

| | FFIRING TEMP. (°C) | SECONDARY PHASE COMPOSITION | PARTICLE SIZE OF SECONDARY PHASE CALCINED POWDER | | |
|---|---|---|---|---|---|
| | | | D20 (μm) | D50 (μm) | D80 (μm) |
| S1 | — | — | — | — | — |
| S2 | 1050 | $Ba_2KNb_5O_{15}$ | 0.05 | 0.2 | 0.5 |
| S3 | 1100 | $Ba_2KNb_5O_{15}$ | 0.05 | 0.2 | 0.5 |
| S4 | 1150 | $Ba_2KNb_5O_{15}$ | 0.05 | 0.2 | 0.5 |
| S5 | 1180 | $Ba_2KNb_5O_{15}$ | 0.05 | 0.2 | 0.5 |
| S6 | 1100 | $Ba_2KNb_5O_{15}$ | 15 | 30 | 80 |
| S7 | 1150 | $Ba_2KNb_5O_{15}$ | 15 | 30 | 80 |
| S8 | 1150 | $BaSrKNb_5O_{15}$ | 0.05 | 0.2 | 0.6 |
| S9 | 1150 | $BaCaKNb_5O_{15}$ | 0.03 | 0.3 | 0.5 |
| S10 | 1150 | $Sr_2NaNb_5O_{15}$ | 0.04 | 0.3 | 0.6 |
| S11 | 1150 | $Ba_2NaNb_5O_{15}$ | 0.07 | 0.2 | 0.7 |
| S12 | 1150 | $Ba_2(K_{0.5},Na_{0.5})Nb_5O_{15}$ | 0.05 | 0.2 | 0.4 |
| S13 | 1150 | $Ba_2KNb_5O_{15}$ | 11 | 32 | 78 |
| S14 | 1150 | $Ba_2KNb_5O_{15}$ | 16 | 23 | 81 |
| S15 | 1150 | $Ba_2KNb_5O_{15}$ | 15 | 31 | 55 |
| S16 | 1150 | $Ba_2KNb_5O_{15}$ | 11 | 22 | 83 |
| S17 | 1150 | $Ba_2KNb_5O_{15}$ | 18 | 22 | 51 |
| S18 | 1150 | $Ba_2KNb_5O_{15}$ | 10 | 33 | 64 |
| S19 | 1150 | $Ba_2KNb_5O_{15}$ | 17 | 21 | 54 |
| S20 | 1050 | $Ba_2KNb_5O_{15}$ | 0.05 | 0.2 | 0.5 |
| S21 | 1050 | $Ba_2KNb_5O_{15}$ | 0.05 | 0.2 | 0.5 |
| S22 | 1050 | $Ba_2KNb_5O_{15}$ | 0.05 | 0.2 | 0.5 |
| S23 | 1050 | $Ba_2KNb_5O_{15}$ | 0.05 | 0.2 | 0.5 |
| S24 | 1050 | $Ba_2KNb_5O_{15}$ | 0.05 | 0.2 | 0.5 |
| S25 | 1050 | $Ba_2KNb_5O_{15}$ | 0.05 | 0.2 | 0.5 |
| S26 | 1050 | $Ba_2KNb_5O_{15}$ | 0.05 | 0.2 | 0.5 |
| S27 | 1050 | $Ba_2KNb_5O_{15}$ | 0.05 | 0.2 | 0.5 |

## INTERNATIONAL SEARCH REPORT

International application No.

**PCT/JP2024/027793**

### A. CLASSIFICATION OF SUBJECT MATTER

*C04B 35/495*(2006.01)i; *H10N 30/20*(2023.01)i; *H10N 30/30*(2023.01)i; *H10N 30/853*(2023.01)i
FI:   C04B35/495; H10N30/853; H10N30/30; H10N30/20

According to International Patent Classification (IPC) or to both national classification and IPC

### B. FIELDS SEARCHED

Minimum documentation searched (classification system followed by classification symbols)

C04B35/495; H10N30/20; H10N30/30; H10N30/853

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2002-293628 A (TDK CORP.) 09 October 2002 (2002-10-09)<br>entire text, all drawings | 1-9 |
| A | JP 2002-338355 A (TDK CORP.) 27 February 2002 (2002-02-27)<br>entire text, all drawings | 1-9 |
| A | JP 2019-031424 A (NGK SPARK PLUG CO., LTD.) 28 February 2019 (2019-02-28)<br>entire text, all drawings | 1-9 |
| A | JP 2023-032022 A (NGK SPARK PLUG CO., LTD.) 09 March 2023 (2023-03-09)<br>entire text, all drawings | 1-9 |
| P, A | WO 2024/070849 A1 (NGK SPARK PLUG CO., LTD.) 04 April 2024 (2024-04-04)<br>entire text, all drawings | 1-9 |
| P, A | WO 2024/070625 A1 (NGK SPARK PLUG CO., LTD.) 04 April 2024 (2024-04-04)<br>entire text, all drawings | 1-9 |

☐ Further documents are listed in the continuation of Box C.          ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **03 September 2024** | **17 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/027793**

| Patent document cited in search report | | | Publication date (day/month/year) | Patent family member(s) | Publication date (day/month/year) |
|---|---|---|---|---|---|
| JP | 2002-293628 | A | 09 October 2002 | (Family: none) | |
| JP | 2002-338355 | A | 27 February 2002 | (Family: none) | |
| JP | 2019-031424 | A | 28 February 2019 | (Family: none) | |
| JP | 2023-032022 | A | 09 March 2023 | (Family: none) | |
| WO | 2024/070849 | A1 | 04 April 2024 | (Family: none) | |
| WO | 2024/070625 | A1 | 04 April 2024 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5715309 B
- JP 6895845 B
- WO 2022215666 A
- WO 2023026614 A